# EUROPEAN PATENT APPLICATION

(11) **EP 4 815 711 A2**
(43) Date of publication of application: **30.09.2026**
(21) Application number: 26197789.6
(22) Date of filing: 05.10.2023
(51) Int. Cl.: H10W 40/10

(54) **FUSE STRUCTURE WITH METAL HEATER AND HEAT SPREADING STRUCTURE FOR FUSE BODY**

(30) Priority: 12.12.2022 US 202218064472
(62) Document number(s) of the earlier application(s) in accordance with Art. 76 EPC: 23201726.9 / 4 386 830
(71) Applicant: GlobalFoundries U.S. Inc., Malta, NY 12020 (US)
(72) Inventor: PANDEY, Shesh Mani, Malta, 12020 (US); LEVY, Mark D., Essex Junction, 05452 (US); TAN, Chung Foong, Malta, 12020 (US)
(74) Representative: Grünecker Patent- und Rechtsanwälte PartG mbB

(57) **Abstract**

A fuse structure includes a fuse body including a polysilicon, and a metal heater over the fuse body. The fuse structure also includes a heating spreading structure thermally coupled to the metal heater and extending horizontally adjacent to at least one side of the fuse body. The metal heater can be a portion of a metal wire or a resistor including a resistive metal. The heat spreading structure may include a plurality of metal contacts.

## Description

### BACKGROUND

The present disclosure relates to fuses, and more specifically, to a fuse structure including a polysilicon fuse body with a metal heater and a heat spreading structure.

Different parts of an integrated circuit (IC) may be coupled using an electrical fuse (e-fuse). E-fuses can be 'programmed' to change interconnections within the IC. More particularly, a fuse body or link can be caused to stop or greatly reduce current flow therethrough by application of a prescribed current controlled, for example, by a transistor. Once sufficient changes have occurred in the fuse body, the fuse body is open or blown, stopping or greatly reducing current from passing through the fuse. One common fuse includes a fuse body made of polysilicon. One challenge presented by polysilicon e-fuses is that they occupy a large footprint in ICs due to the size of the fuse body and the associated current source needed to program them. Polysilicon e-fuses can be heated to reduce the amount of current required to program them. However, current heating approaches are ineffective at delivering sufficient heat to reduce the current required to program the fuse.

Document CN 104 659 013 A discloses an electric fuse structure which comprises a substrate, an electric fuse on the substrate, and a heating structure on the substrate. The electric fuse comprises a fuse, an anode, and a cathode which are respectively located at both ends of the fuse and connected to the fuse. A heating structure on the substrate that is electrically isolated from the electrical fuse by a dielectric layer for transferring the generated heat to the electrical fuse.

### SUMMARY

All aspects, examples and features mentioned below can be combined in any technically possible way.

An aspect of the disclosure provides a fuse structure in accordance with independent claim 1, advantageous embodiments being defined in dependent claims 2 to 11.

Another aspect of the disclosure provides a method in accordance with independent claim 12.

Two or more aspects described in this disclosure, including those described in this summary section, may be combined to form implementations not specifically described herein. The details of one or more implementations are set forth in the accompanying drawings and the description below. Other features, objects and advantages will be apparent from the description and drawings, and from the claims.

### BRIEF DESCRIPTION OF THE DRAWINGS

The embodiments of this disclosure will be described in detail, with reference to the following figures, wherein like designations denote like elements, and wherein:
FIG. 1 shows a perspective view of a fuse structure, according to embodiments of the disclosure;
FIG. 2 shows a Y cross-sectional view of the fuse structure of FIG. 1 along view line 2-2;
FIG. 3 shows an X cross-sectional view of the fuse structure of FIG. 1 along view line 3-3;
FIG. 4 shows a Y cross-sectional view of a fuse structure, according to other embodiments of the disclosure;
FIG. 5 shows an X cross-sectional view of a fuse structure, according to other embodiments of the disclosure;
FIG. 6 shows a Y cross-sectional view of a fuse structure, according to another embodiment of the disclosure;
FIG. 7A shows a Y cross-sectional view of a fuse structure, according to another embodiment of the disclosure;
FIG. 7B shows a Y cross-sectional view of a fuse structure showing alternative arrangements of metal contacts of a heat spreading structure, according to another embodiment of the disclosure;
FIG. 8 shows a top-down view of a fuse structure, according to other embodiments of the disclosure;
FIG. 9 shows a top-down view of a fuse structure, according to yet other embodiments of the disclosure;
FIG. 10 shows a top-down view of a fuse structure, according to other embodiments of the disclosure;
FIG. 11 shows a top-down view of a fuse structure, according to yet other embodiments of the disclosure;
FIG. 12 shows a Y cross-sectional view of a fuse structure, according to another embodiment of the disclosure;
FIG. 13 shows a Y cross-sectional view of a fuse structure, according to other embodiment of the disclosure;
FIG. 14 shows a Y cross-sectional view of a fuse structure, according to yet another embodiment of the disclosure;
FIG. 15 shows a Y cross-sectional view of a fuse structure, according to another embodiment of the disclosure; and
FIG. 16 shows a Y cross-sectional view of a fuse structure, according to yet another embodiment of the disclosure.

It is noted that the drawings of the disclosure are not necessarily to scale. The drawings are intended to depict only typical aspects of the disclosure, and therefore should not be considered as limiting the scope of the disclosure. In the drawings, like numbering represents like elements between the drawings.

### DETAILED DESCRIPTION

In the following description, reference is made to the accompanying drawings that form a part thereof, and in which is shown by way of illustration specific illustrative embodiments in which the present teachings may be practiced. These embodiments are described in sufficient detail to enable those skilled in the art to practice the present teachings, and it is to be understood that other embodiments may be used and that changes may be made without departing from the scope of the present teachings. The following description is, therefore, merely illustrative.

It will be understood that when an element such as a layer, region, or substrate is referred to as being "on" or "over" another element, it may be directly on the other element or intervening elements may also be present. In contrast, when an element is referred to as being "directly on" or "directly over" another element, there may be no intervening elements present. It will also be understood that when an element is referred to as being "connected" or "coupled" to another element, it may be directly connected or coupled to the other element or intervening elements may be present. In contrast, when an element is referred to as being "directly connected" or "directly coupled" to another element, there are no intervening elements present.

Reference in the specification to "one embodiment" or "an embodiment" of the present disclosure, as well as other variations thereof, means that a particular feature, structure, characteristic, and so forth described in connection with the embodiment is included in at least one embodiment of the present disclosure. Thus, the phrases "in one embodiment" or "in an embodiment," as well as any other variations appearing in various places throughout the specification are not necessarily all referring to the same embodiment. It is to be appreciated that the use of any of the following "/," "and/or," and "at least one of," for example, in the cases of "A/B," "A and/or B" and "at least one of A and B," is intended to encompass the selection of the first listed option (A) only, or the selection of the second listed option (B) only, or the selection of both options (A and B). As a further example, in the cases of "A, B, and/or C" and "at least one of A, B, and C," such phrasing is intended to encompass the first listed option (A) only, or the selection of the second listed option (B) only, or the selection of the third listed option (C) only, or the selection of the first and the second listed options (A and B), or the selection of the first and third listed options (A and C) only, or the selection of the second and third listed options (B and C) only, or the selection of all three options (A and B and C). This may be extended, as readily apparent by one of ordinary skill in the art, for as many items listed.

Embodiments of the disclosure include a fuse structure having a fuse body including a polysilicon, and a metal heater over the fuse body. The fuse structure also includes a heat spreading structure thermally coupled to the metal heater and extending horizontally adjacent to at least one side of the fuse body. The metal heater can be a portion of a metal wire or a resistor including a resistive metal. The heat spreading structure may include a plurality of metal contacts. The fuse structure including the heat spreading structure reduces the necessary programming energy and also reduces the size of a programming current source, which will reduce the overall circuitry footprint. The fuse structure does not require any additional masks to implement.

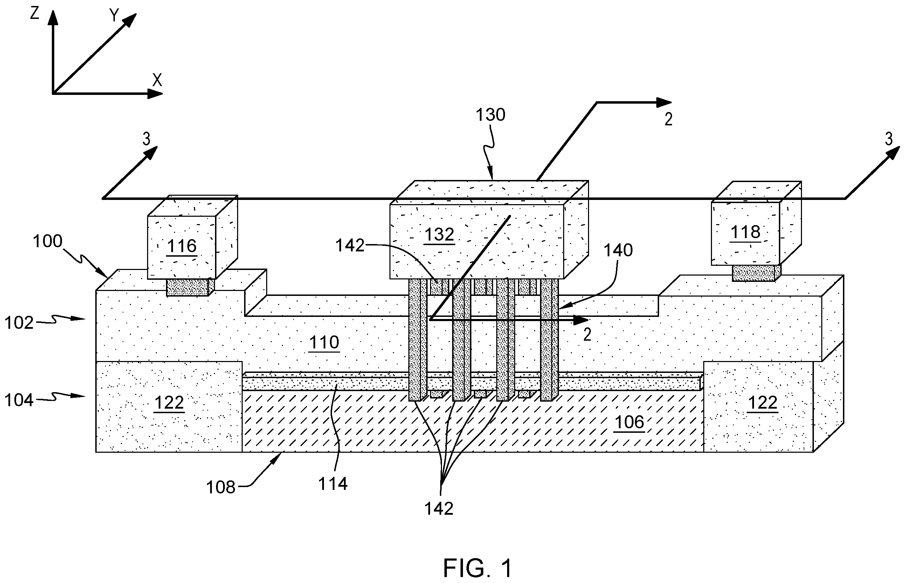

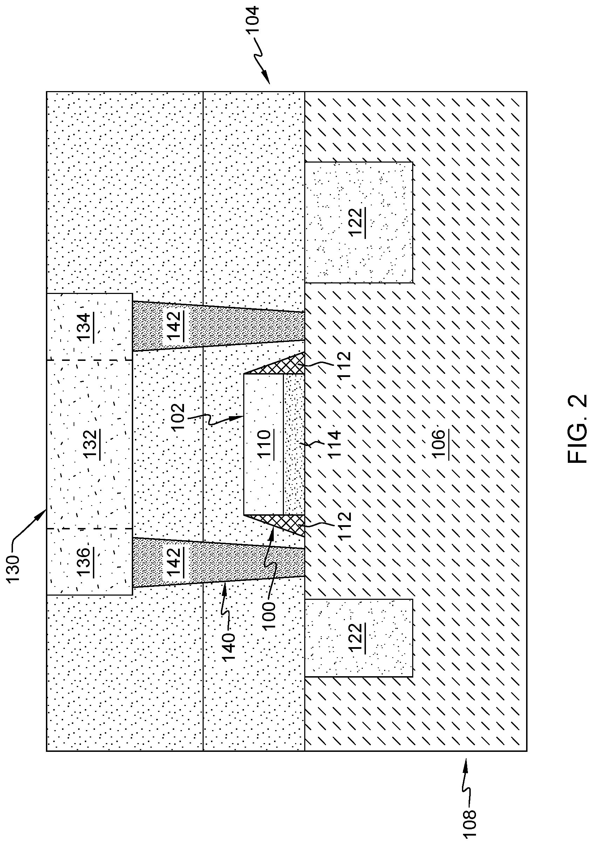

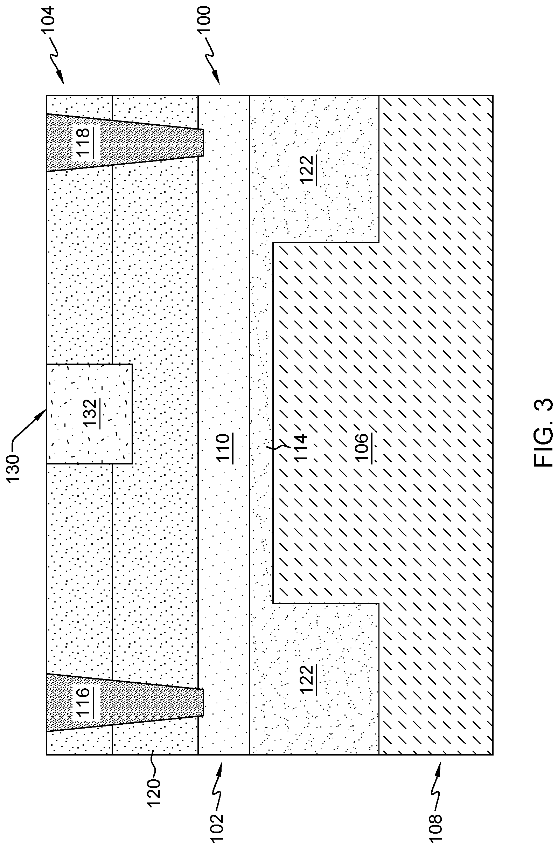

FIG. 1 shows a perspective view of a fuse structure 100 according to embodiments of the disclosure. FIG. 2 shows a Y cross-sectional view of fuse structure 100 in FIG. 1 along view line 2-2 (across fuse body 102), and FIG. 3 shows an X cross-sectional view of fuse structure 100 in FIG. 1 along view line 3-3 (through fuse body 102).

Fuse structure 100 includes a fuse body 102 including a polysilicon. The polysilicon can be any polysilicon used for fuses and/or during formation of other devices such as transistor or resistors (not shown) over an active region 106 of an integrated circuit (IC) structure 104. That is, fuse body 102 may be formed as part of active region 106 of a substrate 108 in IC structure 104 in which fuse structure 100 is used. For purposes of description, substrate 108 is shown as a bulk semiconductor substrate, but it may include any now known or later developed substrate, e.g., fin, nanosheets, semiconductor-on-insulator (SOI). Fuse body 102 may include a polysilicon body 110. Polysilicon body 110 may have a pair of spacers 112 (FIG. 2 only) on opposing sides thereof. Spacers 112 may include any now known or later developed spacer material such as but not limited to silicon nitride. Spacers 112 may be omitted in some cases. Fuse body 102 is on a dielectric layer 114. Dielectric layer 114 may include any now known or later developed gate dielectric materials such as but not limited to hafnium silicate (HfSiO), hafnium oxide (HfO₂), zirconium silicate (ZrSiOₓ), zirconium oxide(ZrO₂), silicon oxide (SiO₂), silicon nitride (Si₃N₄), silicon oxynitride (SiON), high-k material or any combination of these materials.

As shown in FIGS. 1 and 3, fuse structure 100 may include a first fuse electrode 116 and a second fuse electrode 118 coupled to respective opposite ends of fuse body 102. Fuse electrodes 116, 118 may include any form of metal contacts and/or wires extending through interlayer dielectric (ILD) layer(s) 120 (FIG. 3) above fuse body 102. Active region 106 and fuse structure 100 may be further electrically isolated by any variety of trench isolations 122, e.g., trenches filled with silicon oxide.

Fuse structure 100 also includes a metal heater 130 over fuse body 102. As shown in FIG. 1, metal heater 130 (laterally) overlaps at least a portion of fuse body 102 such that heat produced by metal heater 130 heats fuse body 102. A dielectric layer (portion of ILD layer(s) 120) is between fuse body 102 and particularly, polysilicon body 110 thereof and metal heater 130. As will be described, metal heater 130 can take a variety of forms according to embodiments of the disclosure.

In FIGS. 1-3, metal heater 130 includes at least a portion of a metal wire 132. Metal wire 132 can be any now known or later developed wire structure found in IC structure 104. Metal wire 132 and any metal contacts (described herein) can be formed using any now known or later developed semiconductor fabrication techniques. In one non-limiting example, metal wires and metal contacts may be formed by patterning a mask, etching wire and/or contact openings in respective dielectric layer(s). The metal may include refractory metal liner and a metal body. The refractory metal liner (not shown for clarity) may include, for example, ruthenium (Ru), tantalum (Ta), titanium (Ti), tungsten (W), iridium (Ir), rhodium (Rh) and platinum (Pt), etc., or mixtures of thereof. The metal body may be any now known or later developed contact or wire metal such as but not limited to copper (Cu) or tungsten (W). Metal wires 132 may run laterally in any manner required to route electrical signals.

Metal heater 130 may also include a first heater electrode 134 and a second heater electrode 136 coupled to respective opposite ends of metal heater 130 and defining an electrical current path through metal wire 132 of metal heater 130. In FIG. 2, electrodes 134, 136 are shown (dashed lines) as portions of metal wire 132, but could also include metal contacts to the opposite ends of metal heater 130.

Fuse structure 100 also includes a heating spreading structure 140 thermally coupled to metal heater 130 and extending horizontally adjacent to at least one side of fuse body 102. In FIGS. 1-3, heat spreading structure 140 includes a plurality of metal contacts 142. Metal contacts 142 in IC structure 104 can take a couple of forms. Certain metal contacts, such as those used as electrodes 116, 118 for fuse body 102, are operative metal contacts and carry electrical signals/current. Metal contacts 142 that are part of heat spreading structure 140 have the same physical structure as operative metal contacts, but in certain embodiments, may be used solely for communication of heat (thermal communication) from metal heater 130 to fuse body 102 and do not necessarily carry an electrical signal/current. Hence, operative metal contacts such as electrodes 116, 118 may run vertically in any manner required to route electrical signals. Similarly, metal contacts 142 of heat spreading structure 140 may run vertically in any manner to mainly direct heat to fuse body 102. As will be described, in some cases metal contacts 142 may transmit heat and carry current.

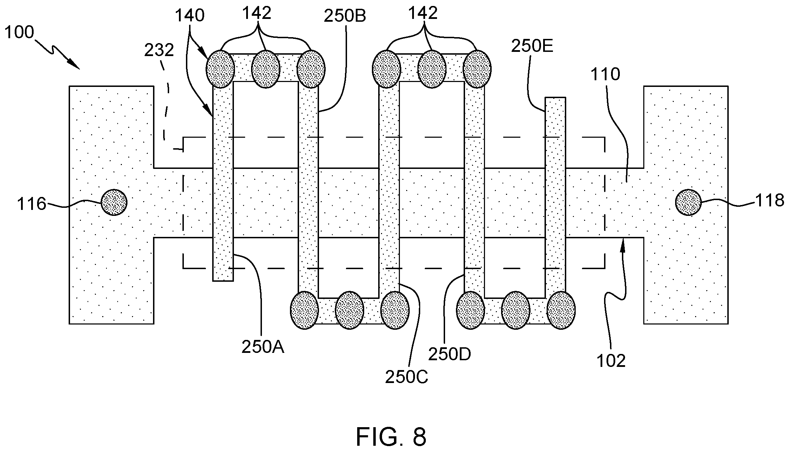

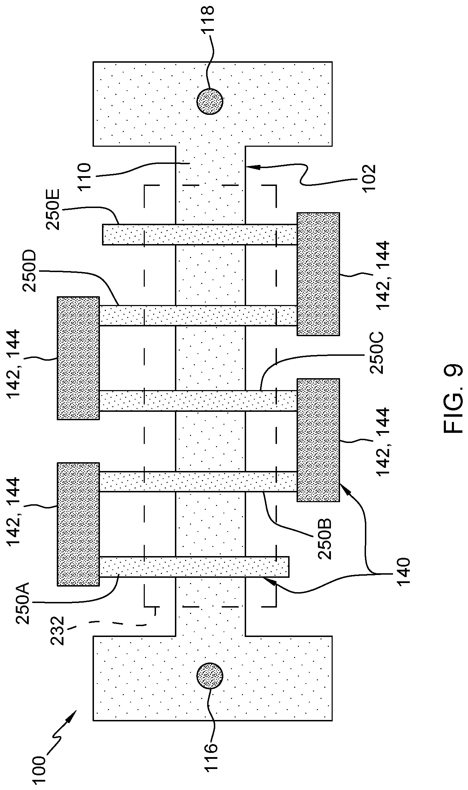

As shown in FIGS. 1 and 2, heat spreading structure 140, e.g., metal contacts 142, extend vertically to be horizontally adjacent to pair of spacers 112 of fuse body 102. Metal contacts 142 do not land on fuse body 102, and may partially land on spacers 112 or land on active region 106 adjacent to fuse body 102. In any event, metal contacts 142 of heat spreading structure 140 are outside the electrical current path of metal heater 130, i.e., there is no current running through metal contacts 142 in this embodiment. Heat from metal heater 130 is delivered by heat spreading structure 140 closer to fuse body 102 than in conventional fuse structures, reducing the necessary programming energy necessary for fuse structure 100. Fuse structure 100 with heat spreading structure 140 also reduces the size of a required programming current source, which reduces the overall circuitry footprint. Also, advantageously, fuse structure 100 does not require any additional masks to implement - metal contacts 142 can be formed at the same time as other operative metal contacts (e.g., electrodes 116, 118 of fuse body 102) of IC structure 104. Metal contacts 142 can have any cross-sectional shape typically used within IC structures such as circular (see e.g., FIG. 8) or bar shaped (see e.g., FIG. 9). In the latter case, metal contacts 142 may become elongated elements 144 (FIG. 9) running parallel to fuse body 102. Metal contacts 142 may also have a cross-sectional dimension configured to create the desired heating of fuse body 102. Further, any number of metal contacts 142 may be used to create the desired heating of fuse body 102. While metal contacts 142 are shown on both sides of fuse body 102, they may be used only on one side.

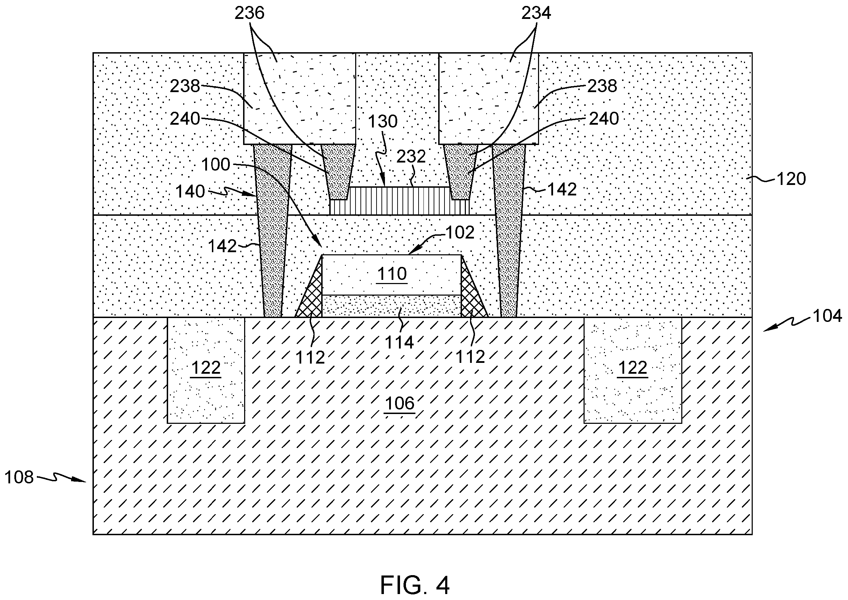

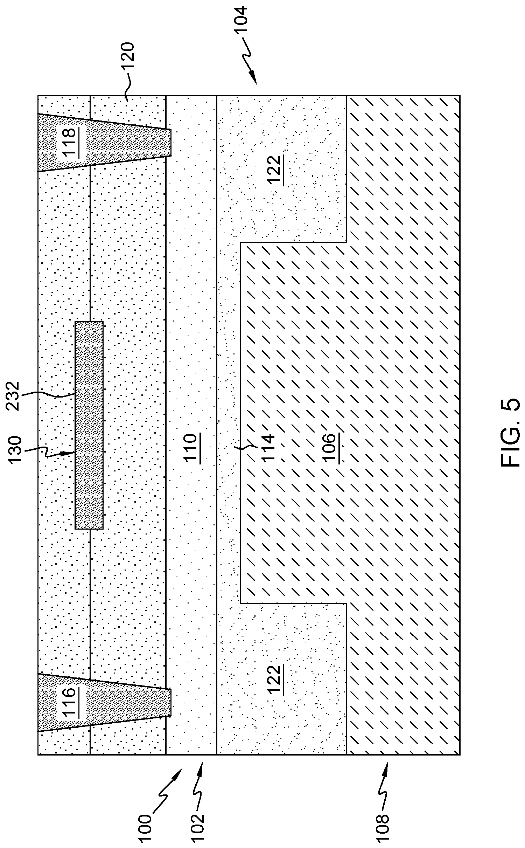

FIG. 4 shows a Y cross-sectional view of fuse structure 100 (similar to FIG. 2), and FIG. 5 shows an X cross-sectional view of fuse structure 100 (similar to FIG. 3), according to another embodiment of the disclosure. In this embodiment, fuse structure 100 includes metal heater 130 in the form of a resistor 232 including a resistive metal. The resistive metal may include any now known or later developed metal or metal alloy used for a resistor element such as but not limited to: titanium, tantalum nitride, tungsten silicide or tungsten polysilicon. As in FIGS. 1-3, heat spreading structure 140 may include plurality of metal contacts 142 in thermal contact with metal heater 130, but here the metal heater includes resistor 232. Heat spreading structure 140, e.g., metal contacts 142, extend vertically to be horizontally adjacent to fuse body 102, e.g., pair of spacers 112 of fuse body 102. Metal contacts 142 do not land on fuse body 102, and may partially land on spacers 112 or land on active region 106 adjacent to fuse body 102.

Metal heater 130 in the form of resistor 232 may include a first heater electrode 234 and a second heater electrode 236 coupled to respective opposite ends of resistor 232, and defining an electrical current path through resistor 232. In FIG. 4, electrodes 234, 236 are shown as metal wires 238 with contacts 240 thereunder, however, they could take other forms. While the contacts for electrodes 234, 236 are shown as separate from metal contacts 142, they may be one structure, e.g., with metal contacts 142 partially landing on resistor 232 and partially extending vertically to be horizontally adjacent to pair of spacers 112 of fuse body 102.

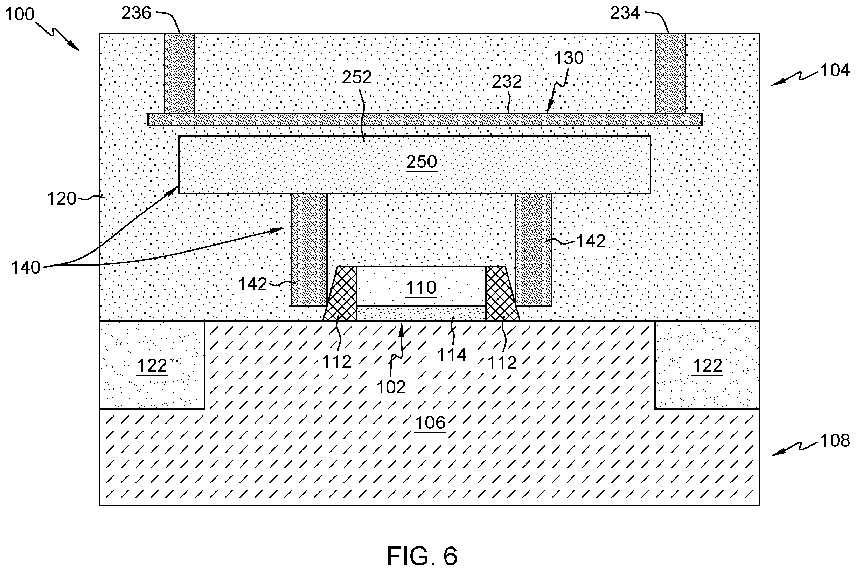

FIG. 6 shows a Y cross-sectional view of fuse structure 100 (similar to FIGS. 2 and 4), according to another embodiment of the disclosure. In this embodiment, metal heater 130 includes resistor 232 with first heater electrode 234 and second heater electrode 236 extending vertically thereabove. As in FIGS. 4-5, heat spreading structure 140 may include plurality of metal contacts 142 in thermal contact with resistor 232. Heat spreading structure 140, e.g., metal contacts 142, extend vertically to be horizontally adjacent to fuse body 102, e.g., pair of spacers 112 of fuse body 102. Metal contacts 142 do not land on fuse body 102, and may partially land on spacers 112 or land on active region 106 adjacent to fuse body 102. However, in this embodiment, metal contacts 142 are not directly coupled to resistor 232. In contrast, heat spreading structure 140 also includes a metal wire 250 thermally coupling metal contacts 142 together. In FIG. 6, resistor 232 is over metal wire 250. A thin dielectric layer 252 (part of ILD layer(s) 120) may separate resistor 232 and metal wire 250. In this manner, resistor 232 heats metal wire 250 and the heat is transferred laterally over fuse body 102 and then vertically thereto by metal contacts 142.

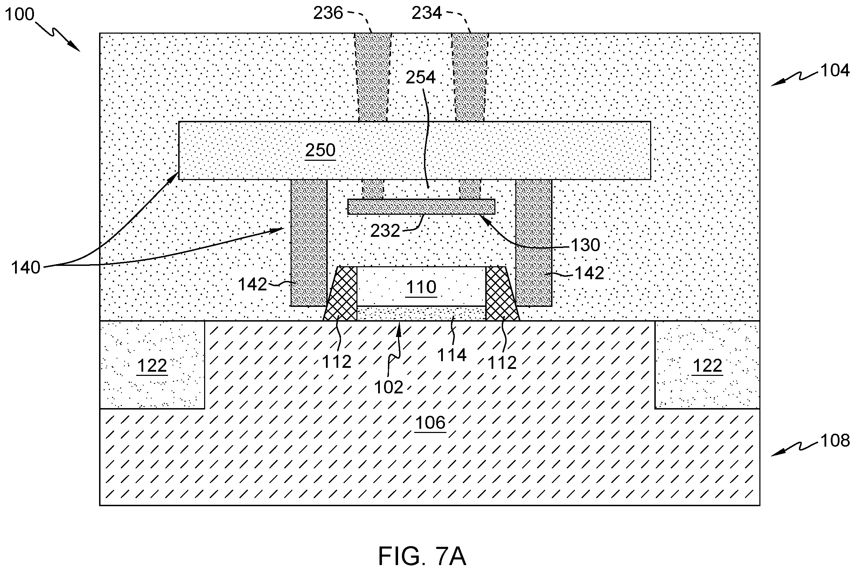

FIG. 7A shows a Y cross-sectional view of fuse structure 100, according to another embodiment of the disclosure. FIG. 7A is similar to FIG. 6, except resistor 232 is between metal wire 250 and fuse body 102, i.e., metal wire 250 is above resistor 232. Heater electrodes 234, 236 are routed to avoid metal wire 250, i.e., to the sides of metal wire 250, and metal contacts 142 of heat spreading structure 140 are routed to avoid resistor 232, i.e., to the sides of resistor 232. A thin dielectric layer 254 (part of ILD layer(s) 120) may separate resistor 232 and metal wire 250. Here, again, resistor 232 heats metal wire 250 and the heat is transferred laterally over fuse body 102 and then vertically thereto by metal contacts 142.

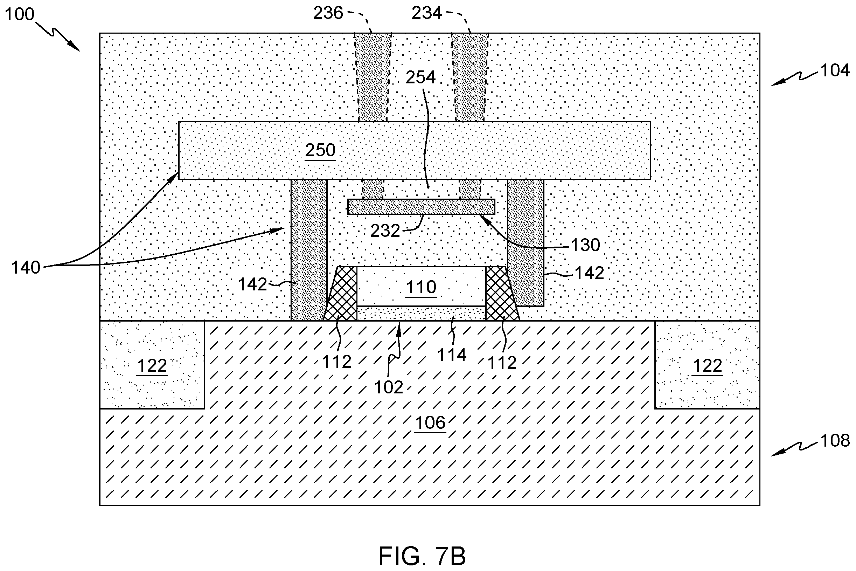

FIG. 7B shows a Y cross-sectional view of fuse structure 100 showing various landing arrangements of metal contacts 142 of heat spreading structure 140, according to alternative embodiments of the disclosure. While shown with the FIG. 7A embodiment, the various alternative embodiments of metal contacts 142 can be applied to any embodiment disclosed herein. In FIGS. 6 and 7A, metal contacts 142 of fuse structure 100 do not land on any structure, but simply pass next to spacers 112. In one alternative arrangement, shown on the left side of FIG. 7B, metal contacts 142 may land on active region 106, i.e., they contact and stop on active region 106. (See also FIGS. 2, 4 and 12-16). In another alternative arrangement, shown on the right side of FIG. 7B, metal contacts 142 may at least partially land on spacer 112, e.g., depending on a width of spacer 112. While each drawing shows a particular landing arrangement for metal contacts 142, metal contacts 142 within a given heat spreading structure 140 and/or fuse structure 100 may include any landing arrangement. That is, metal contacts 142 within given heat spreading structure 140 and/or fuse structure 100 can have different landing arrangements.

FIGS. 8 and 9 show top-down views of fuse structure 100 according to another embodiment. FIGS. 8 and 9 are similar to FIGS. 6 and 7, but in this embodiment, metal wire 250 of heat spreading structure 140 includes a plurality of metal wires 250A-E extending over fuse body 102. Each metal wire 250A-E may couple to at least a portion of the plurality of metal contacts 142, e.g., one or more of the metal contacts 142. In FIGS. 8 and 9, metal heater 130 may include resistor 232 (shown in dashed lines to indicate it can be above or below metal wires 250A-E). While five metal wires 250A-E are shown arranged in a sinusoidal layout, any number of metal wires 250 may be used and may be coupled to any number of metal contacts 142 to provide the desired heat transfer to fuse body 102.

FIGS. 8 and 9 also show a couple of the cross-sectional shape options, among others, of metal contacts 142. FIG. 8 shows a circular cross-section, and FIG. 9 shows a bar shaped cross-section. As shown in FIG. 9, metal contacts 142 may become elongated elements 144 running parallel to fuse body 102. As noted, metal contacts 142 may also have a cross-sectional dimension configured to create the desired heating of fuse body 102. Further, any number of metal contacts 142 may be used to create the desired heating of fuse body 102. Again, while metal contacts 142 are shown on both sides of fuse body 102, they may be used only on one side.

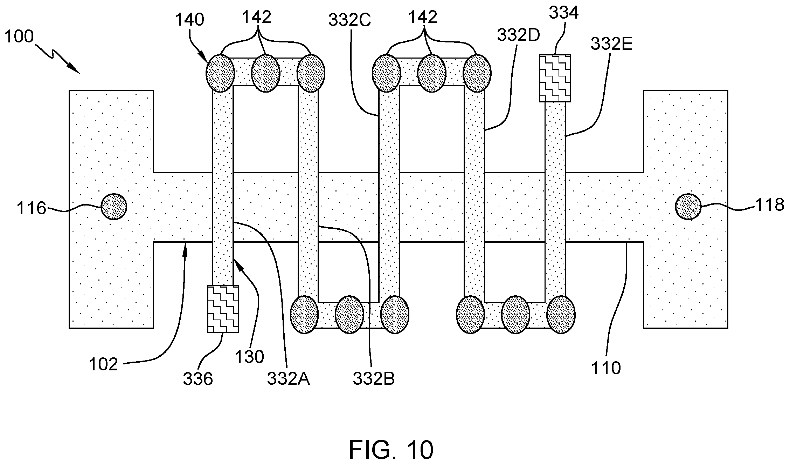

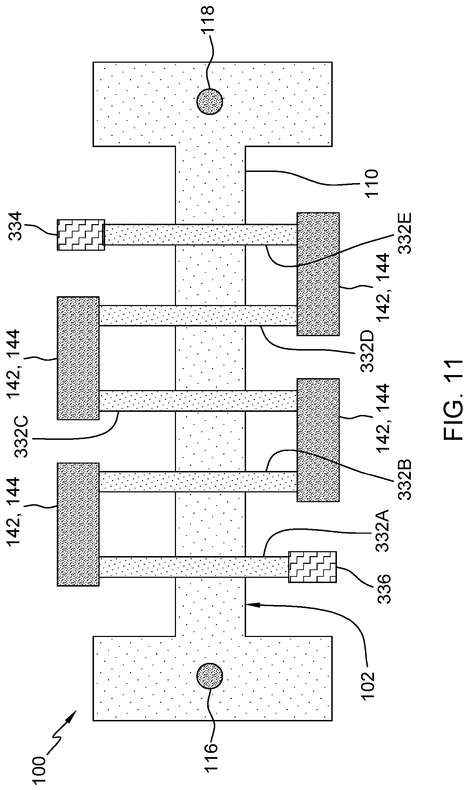

FIG. 10 and 11 show top-down views of fuse structure 100 according to another embodiment. FIGS. 10 and 11 are similar to FIGS. 8 and 9, except a metal wire 260 is not part of heat spreading structure 140, but part of metal heater 130. In this case, metal heater 130, as in FIGS. 1-3, includes a plurality of metal wires 332A-E extending over fuse body 102. Each metal wire 332A-E may couple to a least a portion of metal contacts 142 of heat spreading structure 140. While five metal wires 332A-E are shown arranged in a sinusoidal layout, any number of metal wires 332 may be used as part of metal heater 130, and may be coupled to any number of metal contacts 142 of heat spreading structure 140 to provide the desired heat transfer to fuse body 102.

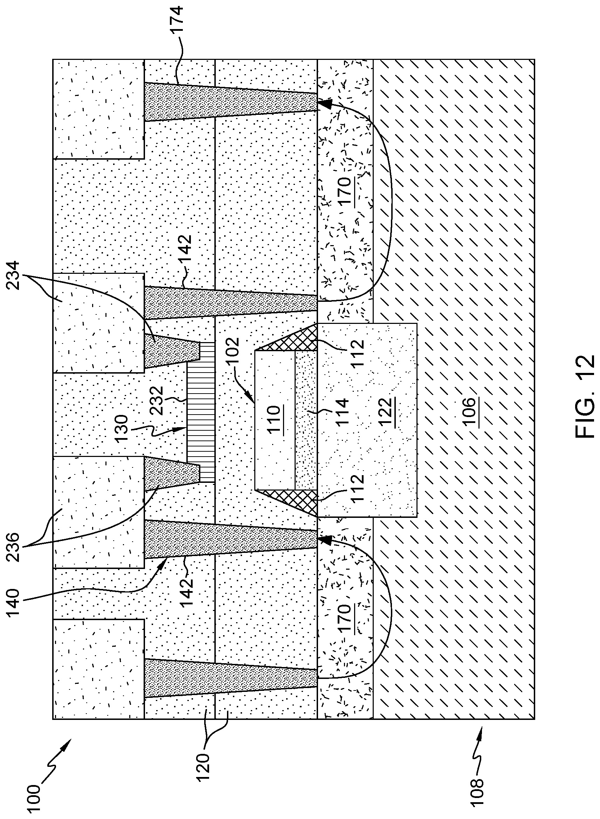

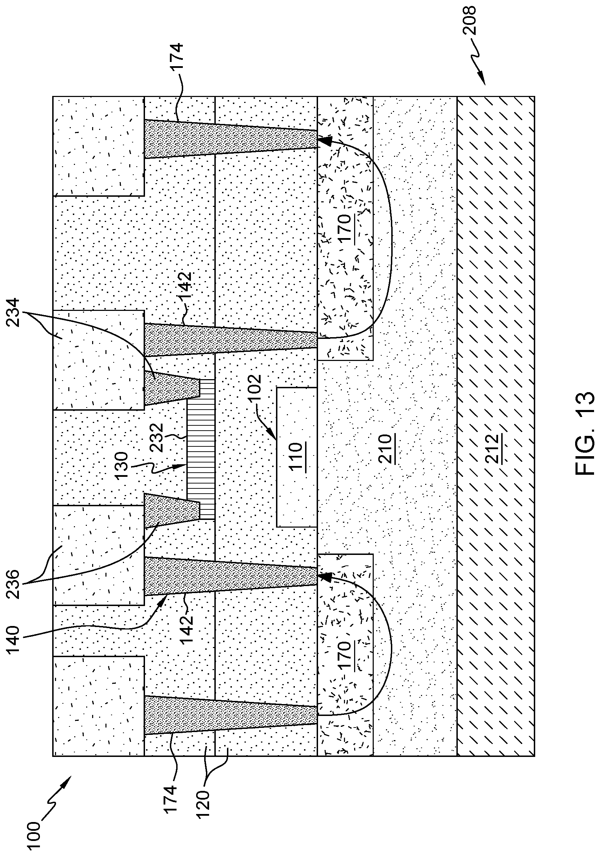

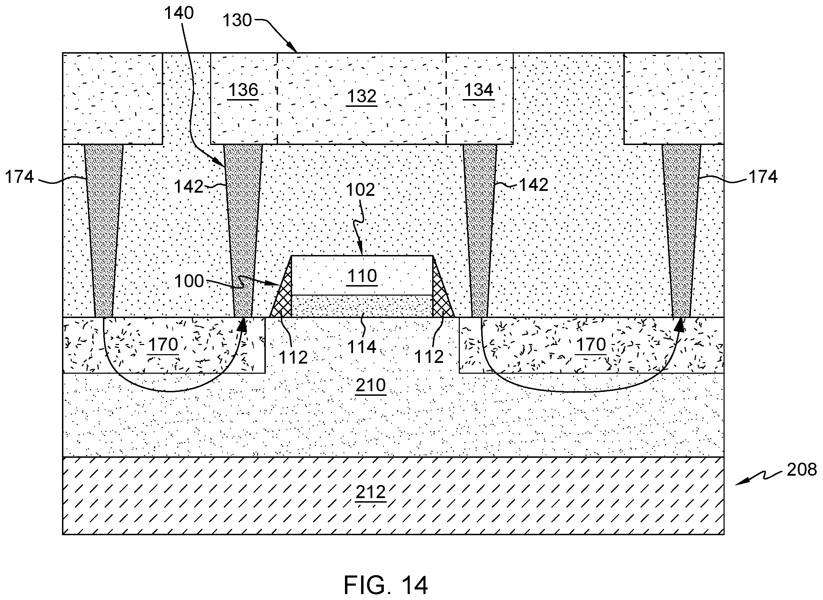

FIGS. 12-14 show Y cross-sectional views of fuse structure 100, according to other embodiments of the disclosure. More particularly, FIGS. 12-14 show previous embodiments including additional heating features for heating fuse body 102. In these embodiments, fuse structure 100 may include additional heating features in the form of a doped region 170 in substrate 108 below and to each side of fuse body 102 and a contact 174 landing on each doped region 170. Doped regions 170 are shown as n-type doped regions (n+), but they could be doped p-type depending on the type of transistors to be used elsewhere in IC structure 104. A portion of the plurality of metal contacts 142 land on each of the doped regions 170. FIG. 12 shows the additional heating features applied to the FIGS. 4-5 embodiment. FIG. 13 shows the additional heating feature applied to the FIGS. 4-5 embodiment, but including a semiconductor-on-insulator (SOI) substrate 208 application. SOI substrate 208 includes a semiconductor-on-insulator (SOI) layer (not shown) over a buried insulator layer 210 over a base semiconductor layer 212. FIG. 14 shows the additional heating features applied to the FIGS. 1-3 embodiment with an SOI substrate 208, like in FIG. 13.

In FIGS. 12-14, current can be directed through one doped region 170 (left side) using contact 174 (left side) to heat fuse body 102 from underneath and to the side using doped region 170 (left side). Current can then pass vertically upward through metal contacts 142 to metal heater 130, through metal heater 130 (resistor 232 in FIGS. 12-13, metal wire 132 in FIG. 14), and then vertically downward through metal contacts 142. Metal contacts 142 thus carry current and thermally communicate heat to fuse body 102 to/from metal heater 130. Current can pass from metal contacts 142 through the other doped region 170 (right side) to further heat fuse body 102 from underneath and to the side using doped region 170 (right side). Current can then pass out through contact 174 (right side). In this manner, the additional heating features of doped regions 170 can add more heat to fuse body 102.

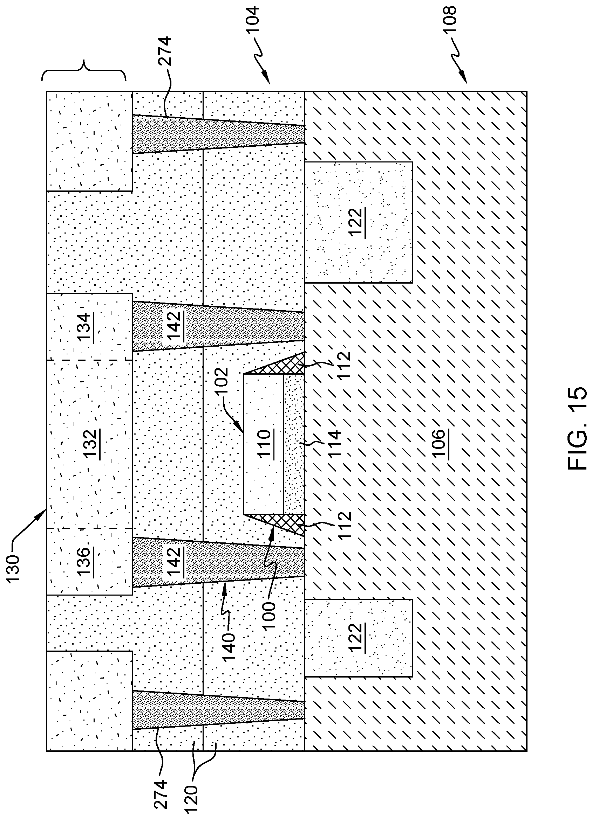

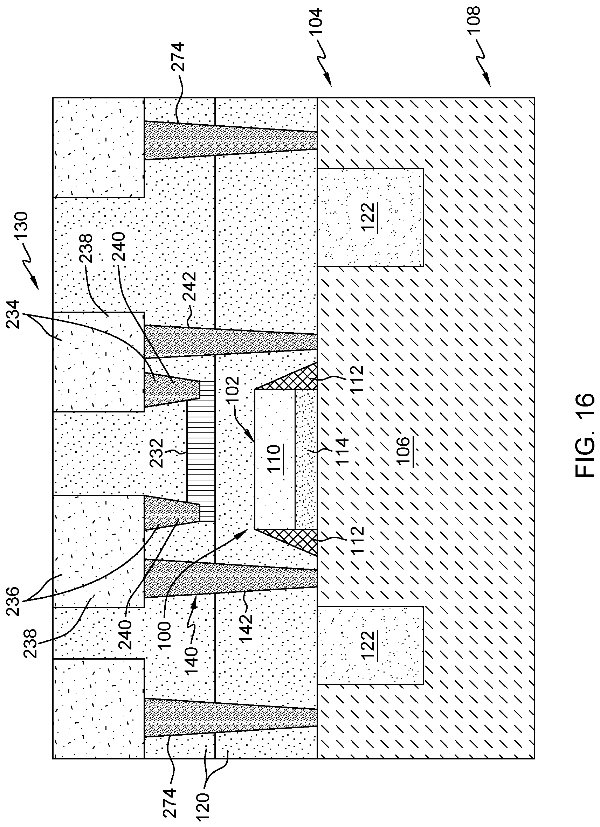

FIGS. 15-16 show Y cross-sectional views of fuse structure 100, according to other embodiments of the disclosure. FIGS. 15-16 show previous embodiments including additional heating features for heating fuse body 102. More particularly, fuse structure 100 may include additional heating features in the form of additional metal contacts 274 landing on active region 106 to the sides of fuse body 102. FIG. 15 shows the additional metal contacts 274 applied to the FIGS. 2-3 embodiments. FIG. 16 shows the additional metal contacts 274 applied to the FIGS. 4-5 embodiment. In FIGS. 15-16, current can be directed through one additional contact 274 (left side) to heat fuse body 102 from underneath and to the side using active region 106 (left side). Current can then pass vertically upward through metal contacts 142 to metal heater 130 (metal wire 132 in FIG. 15, resistor 232 in FIG. 16), through metal heater 130, and then vertically downward through metal contacts 142. Metal contacts 142 thus carry current and thermally communicate heat to fuse body 102 from metal heater 130. Current can pass from metal contacts 142 through active region 106 (right side) to further heat fuse body 102 from underneath and to the side using active region 106 (right side). Current can then pass out through metal contact 274 (right side). In this manner, the additional heating features are provided using active region 106 to add more heat to fuse body 102.

A method for heating a fuse in IC structure 104 according to embodiments of the disclosure may include heating an area over fuse body 102 using metal heater 130, and spreading heat from metal heater 130 through heat spreading structure 140 thermally coupled to metal heater 130 and extending horizontally adjacent to at least one side of fuse body 102.

Embodiments of the disclosure provide various technical and commercial advantages, examples of which are discussed herein. Embodiments of the disclosure provide a fuse structure that reduces the necessary programming energy and also reduces the size of a programming current source, which will reduce the overall circuitry footprint. As described, the fuse structure does not require any additional masks to implement.

With respect to Fig. 15-16, the following embodiments are further disclosed, wherein a fuse structure 100 is provided, this fuse structure 100 comprising: a fuse body 102 including a polysilicon; a metal heater 130 on or over the fuse body 102; and a heat spreading structure 140 thermally coupled to the metal heater 130 and extending horizontally adjacent to at least one side of the fuse body 102. Herein, the heat spreading structure 140 includes a plurality of metal contacts 142 and first and second additional metal contacts 274 landing on respective first and second portions of an active region 106 on opposite sides of the fuse body 102, wherein an electrical current path extends from the first additional metal contact 274 through the first portion of the active region 106, metal contacts 142 on a first side of the fuse body 102, the metal heater 130, metal contacts 142 on a second side of the fuse body 102, and the second portion of the active region 106 to the second additional metal contact 274.

In some illustrative embodiments herein, the fuse structure 100 may further comprise a first heater electrode 134, 234 and a second heater electrode 136, 236 coupled to respective opposite ends of the metal heater 130.

In some illustrative embodiments herein, the plurality of metal contacts 142 may each have one of a circular or bar cross-sectional shape in a top-down view.

In some illustrative embodiments herein, the metal heater 130 may include at least a portion of a metal wire 132.

In some illustrative embodiments herein, the metal heater 130 may include a resistor 232 including a resistive metal.

In some illustrative embodiments herein, the fuse body 102 may be on a dielectric layer 114.

In some illustrative embodiments herein, the metal heater 130 may laterally overlap at least a portion of the fuse body 102.

In some illustrative embodiments herein, the fuse body 102 may include a polysilicon body 110 having a pair of spacers on opposing sides thereof, and the heat spreading structure 140 extends horizontally adjacent to the pair of spacers. In some illustrative examples herein, the fuse structure 100 may further comprise a dielectric layer, for example the dielectric layer 114, between the polysilicon body 110 and the metal heater 130.

In some illustrative embodiments herein, the fuse structure 100 may further comprise a first fuse electrode 116 and a second fuse electrode 118 coupled to respective opposite ends of the fuse body 102.

The structure and method as described above are used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher-level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The terminology used herein is for the purpose of describing particular embodiments only and is not intended to be limiting of the disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. "Optional" or "optionally" means that the subsequently described event or circumstance may or may not occur, and that the description includes instances where the event occurs and instances where it does not.

Approximating language, as used herein throughout the specification and claims, may be applied to modify any quantitative representation that could permissibly vary without resulting in a change in the basic function to which it is related. Accordingly, a value modified by a term or terms, such as "about", "approximately" and "substantially", are not to be limited to the precise value specified. In at least some instances, the approximating language may correspond to the precision of an instrument for measuring the value. Here and throughout the specification and claims, range limitations may be combined and/or interchanged, such ranges are identified and include all the sub-ranges contained therein unless context or language indicates otherwise. "Approximately" as applied to a particular value of a range applies to both values, and unless otherwise dependent on the precision of the instrument measuring the value, may indicate +/-10% of the stated value(s).

The corresponding structures, materials, acts, and equivalents of all means or step plus function elements in the claims below are intended to include any structure, material, or act for performing the function in combination with other claimed elements as specifically claimed. The description of the present disclosure has been presented for purposes of illustration and description, but is not intended to be exhaustive or limited to the disclosure in the form disclosed. Many modifications and variations will be apparent to those of ordinary skill in the art without departing from the scope and spirit of the disclosure. The embodiment was chosen and described in order to best explain the principles of the disclosure and the practical application, and to enable others of ordinary skill in the art to understand the disclosure for various embodiments with various modifications as are suited to the particular use contemplated.

In summary, the following embodiments are explicitly disclosed.
Embodiment 1: A fuse structure, comprising:
   a fuse body including a polysilicon;
   a metal heater on or over the fuse body; and
   a heating spreading structure thermally coupled to the metal heater and extending horizontally adjacent to at least one side of the fuse body. In illustrative examples herein, the metal heater may be directly on the fuse body or over the fuse body without direct contact.
Embodiment 2: The fuse structure of embodiment 1, wherein the heat spreading structure includes a plurality of metal contacts.
Embodiment 3: The fuse structure of embodiment 1 or 2, further comprising a first heater electrode and a second heater electrode coupled to respective opposite ends of the metal heater. In some illustrative examples herein, the first and second heater electrodes may define an electrical current path through the metal heater and the plurality of metal contacts may be outside the electrical current path when combining illustrative examples of embodiment 3 with embodiment 2.
Embodiment 4: The fuse structure of embodiment 2 or 3, wherein the plurality of metal contacts each have one of a circular or bar cross-sectional shape in a top-down view.
Embodiment 5: The fuse structure of one of embodiments 2 to 4, further comprising a doped region in a substrate below and to each side of the fuse body and a contact landing on each doped region, wherein a portion of the plurality of metal contacts land on each of the doped regions.
Embodiment 6: The fuse structure of one of embodiments 1 to 5, wherein the metal heater includes at least a portion of a metal wire.
Embodiment 7: The fuse structure of one of embodiments 1 to 6, wherein the metal heater includes a resistor including a resistive metal, and the heat spreading structure includes a plurality of metal contacts in thermal contact with the resistor.
Embodiment 8: The fuse structure of embodiment 7, further comprising a metal wire thermally coupling the plurality of metal contacts together. For example, when considering a combination of embodiments 8 and 6, the metal heater of embodiment 6 includes the metal wire.
Embodiment 9: The fuse structure of embodiment 8, wherein the resistor is between the metal wire and the fuse body.
Embodiment 10: The fuse structure of embodiment 8 or 9, wherein the resistor is over the metal wire.
Embodiment 11: The fuse structure of one of embodiments 8 to 10, wherein the metal wire includes a plurality of metal wires extending over the fuse body, each metal wire coupling to a least a portion of the plurality of metal contacts.
Embodiment 12: The fuse structure of one of embodiments 1 to 11, wherein the fuse body is on or over a dielectric layer. For example, the fuse body may be directly on the dielectric layer.
Embodiment 13: The fuse structure of one of embodiments 1 to 12, further comprising a first fuse electrode and a second fuse electrode coupled to respective opposite ends of the fuse body.
Embodiment 14: The fuse structure of one of embodiments 1 to 13, wherein the metal heater laterally overlaps at least a portion of the fuse body.
Embodiment 15: The fuse structure of one of embodiments 1 to 14, wherein the fuse body includes a polysilicon body having a pair of spacers on opposing sides thereof, and the heat spreading structure extends horizontally adjacent to the pair of spacers.
Embodiment 16: The fuse structure of embodiment 15, further comprising a dielectric layer between the polysilicon body and the metal heater.
Embodiment 17: A fuse structure comprising:
   a fuse body on or over a dielectric layer, the fuse body including a polysilicon;
   a first fuse electrode and a second fuse electrode coupled to respective opposite ends of the fuse body;
   a metal heater above the fuse body and laterally overlapping at least a portion of the fuse body; heater electrodes, e.g., a first heater electrode and a fourth heater electrode (which may be considered as representing a second heater electrode) coupled to respective opposite ends of the metal heater and defining an electrical current path through the metal heater;
   a heat spreading structure extending adjacent to the fuse body, the heat spreading structure coupled to the metal heater. In some illustrative examples herein, the fuse body may be directly on the dielectric layer or over the dielectric layer without direct contact.
Embodiment 18: The fuse structure of embodiment 17, wherein the metal heater includes at least a portion of a metal wire, and the heat spreading structure includes a plurality of metal contacts in thermal contact with the metal heater.
Embodiment 19: The fuse structure of embodiment 17 or 18, wherein the metal heater includes a resistor including a resistive metal, and the heat spreading structure includes a plurality of metal contacts in thermal contact with the resistor.
Embodiment 20: A method for heating a fuse in an integrated circuit (IC) structure, the fuse including a fuse body including polysilicon, the method comprising:
   heating an area over the fuse body using a metal heater; and
   spreading heat from the metal heater through a heat spreading structure thermally coupled to the metal heater and extending horizontally adjacent to at least one side of the fuse body.
Embodiment 21: The method of embodiment 20, wherein the fuse structure of one of embodiments 1 to 19 is formed.

At least in the embodiments above, the term "include" and its variants may be interpreted as meaning that an embodiment includes stated features, while not necessarily excluding the presence of other features that are not explicitly stated.

## Claims

1. A fuse structure (100), comprising:
a fuse body (102) including a polysilicon;
a metal heater (130) on or over the fuse body (102);
a heating spreading structure (140) thermally coupled to the metal heater (130) and extending horizontally adjacent to at least one side of the fuse body (102), wherein the heat spreading structure (140) includes a plurality of metal contacts (142); and
a doped region (170) in a substrate (108) below and to each side of the fuse body (102) and a contact (174) landing on each doped region (170), wherein a portion of the plurality of metal contacts (142) land on each of the doped regions (170).

2. The fuse structure (100) of claim 1, further comprising a first heater electrode (234) and a second heater electrode (236) coupled to respective opposite ends of the metal heater (130) and defining an electrical current path through the metal heater (130).

3. The fuse structure (100) of claim 1 or 2, wherein the plurality of metal contacts (142) each have one of a circular or bar cross-sectional shape in a top-down view.

4. The fuse structure (100) of one of claims 1 to 3, wherein the metal heater (130) includes at least a portion of a metal wire (132).

5. The fuse structure (100) of one of claims 1 to 4, wherein the metal heater (130) includes a resistor (232) including a resistive metal, and the heat spreading structure (140) includes a plurality of metal contacts (142) in thermal contact with the resistor (232).

6. The fuse structure (100) of claim 5, further comprising a metal wire (132) thermally coupling the plurality of metal contacts (142) together, the metal wire (132) preferably including a plurality of metal wires (132) extending over the fuse body (102), each of the metal wires (132) coupling to a least a portion of the plurality of metal contacts (142).

7. The fuse structure (100) of claim 6, wherein the resistor (232) is between the metal wire (132) and the fuse body (102) or the resistor (232) is over the metal wire (132).

8. The fuse structure (100) of one of claims 1 to 7, wherein:
the fuse body (102) is on a dielectric layer (114); and/or
the metal heater (130) laterally overlaps at least a portion of the fuse body (102).

9. The fuse structure (100) of one of claims 1 to 8, wherein the fuse body (102) includes a polysilicon body (110) having a pair of spacers (112) on opposing sides thereof, and the heat spreading structure (140) extends horizontally adjacent to the pair of spacers (112), the fuse structure (100) preferably further comprising a dielectric layer (114) between the polysilicon body (110) and the metal heater (130).

10. The fuse structure (100) of one of claims 1 to 9, further comprising a first fuse electrode (234) and a second fuse electrode (236) coupled to respective opposite ends of the fuse body (102).

11. The fuse structure (100) of one of claims 1 to 9, further comprising:
a first fuse electrode (234) and a second fuse electrode (236) coupled to respective opposite ends of the fuse body (102); and
heater electrodes (234, 236) coupled to respective opposite ends of the metal heater (130) and defining an electrical current path through the metal heater (130),
wherein the metal heater (130) laterally overlaps at least a portion of the fuse body (102), and
wherein the fuse body (102) is formed on a dielectric layer (114).

12. A method for heating a fuse in an integrated circuit structure (104), the fuse including the fuse structure (100) of one of claims 1 to 11, the method comprising:
heating an area over the fuse body (102) using a metal heater (130); and
spreading heat from the metal heater (130) through a heat spreading structure (140) thermally coupled to the metal heater (130) and extending horizontally adjacent to at least one side of the fuse body (102).
